# EUROPÄISCHE PATENTSCHRIFT

(11) **EP 3 537 012 B1**
(45) Veröffentlichungstag und Bekanntmachung des Hinweises auf die Patenterteilung: **29.07.2020**
(21) Anmeldenummer: 19159882.0
(22) Anmeldetag: 28.02.2019
(51) Int. Cl.: F16J 15/3284, F16J 15/06, H05K 9/00

(54) **DICHTUNG**
SEAL
JOINT D'ÉTANCHÉITÉ

(30) Priorität: 08.03.2018 DE 102018105375
(43) Veröffentlichungstag der Anmeldung: 11.09.2019
(73) Patentinhaber: Carl Freudenberg KG, 69469 Weinheim (DE)
(72) Erfinder: Colineau, Francois, 69469 Weinheim (DE); Hofmann, Jens, 68305 Mannheim (DE); Klenk, Dr. Thomas, 69221 Dossenheim (DE)

(56) Entgegenhaltungen:
- DE-A1- 2 621 352
- DE-A1-102013 000 982
- FR-A1- 2 446 971
- JP-A- 2014 207 822

## Beschreibung

### Technisches Gebiet

Die Erfindung betrifft eine Dichtung, umfassend einen Dichtring aus einem Dichtungswerkstoff.

### Stand der Technik

Eine solche Dichtung ist allgemein bekannt, wobei der Dichtring beispielsweise als Radialwellendichtring ausgebildet ist und aus einem elastomeren Werkstoff besteht. Der Dichtring weist zumindest eine dynamisch beanspruchte Dichtlippe auf, die eine abzudichtende Oberfläche eines abzudichtenden Maschinenelements unter elastischer Vorspannung dichtend umschließt.

Aus der DE 26 21 352 A1 ist eine Magnetdichtung bekannt. Die Magnetdichtung umfasst ein Trägerteil aus Metall oder Kunststoff und ein daran angeordnetes Dichtelement, insbesondere zur Abdichtung von Wellen. Am Trägerteil und/oder am Dichtelement ist ein dauermagnetisches Element vorgesehen, durch dessen magnetische Kräfte das Dichtelement während der bestimmungsgemäßen Verwendung der Dichtung an die Welle angepresst wird.

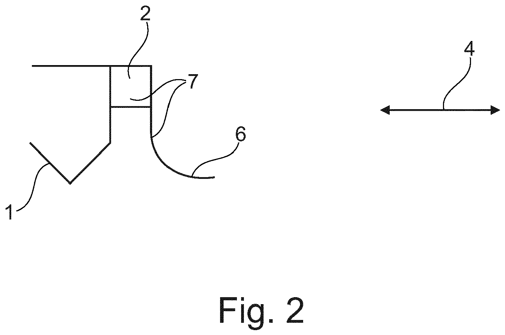

Das dauermagnetische Element kann zum Beispiel durch eine permanentmagnetische Schicht gebildet sein, die auf der der Welle radial abgewandten Seite des Dichtelements angeordnet ist. Im Trägerteil kann zusätzlich ein feststehender Dauermagnet angeordnet sein, dessen dem Dichtelement zugewandte Seite die gleiche magnetische Poligkeit aufweist, wie die dem Dauermagnet zugewandte Seite der magnetischen Schicht. Bevorzugt besteht das Trägerteil aus einem Kunststoff. Das hat den Vorteil, dass das Trägerteil unmittelbar auf das Dichtelement aufgespritzt werden kann, ohne dass für den Zusammenbau ein separater Arbeitsgang erforderlich wäre. In Figur 2 der zuvor genannten Schrift ist eine Ausführungsform einer Magnetdichtung gezeigt, deren Funktion unabhängig von einer Magnetisierbarkeit der abzudichtenden Welle ist. Im Trägerteil ist zusätzlich ein Dauermagnet angeordnet, dessen der permanentmagnetischen Schicht zugewandte Seite dieselbe magnetische Poligkeit aufweist. Das Dichtelement wird durch die dadurch auftretenden magnetischen Abstoßkräfte an die Dichtfläche der abzudichtenden Welle angepresst.
Ein elektrischer Potentialausgleich zwischen der Welle und einem Gehäuse, das die Welle umschließt, kann durch die vorbekannte Magnetdichtung nicht erfolgen.

Aus der DE 10 2013 000 982 A1 ist eine Dichtung bekannt, die einen Dichtring mit zumindest einer dynamisch beanspruchten Dichtlippe und einer Vorschaltdichtung umfasst. Die Vorschaltdichtung ist mit axialem Abstand benachbart zur Dichtlippe angeordnet und besteht aus einem elektrisch leitfähigen Werkstoff. Die Dichtlippe und die Vorschaltdichtung umschließen eine abzudichtende Oberfläche eines abzudichtenden ersten Maschinenelements dichtend, wobei das erste Maschinenelement mit radialem Abstand benachbart zu einem zweiten Maschinenelement angeordnet ist. In dem durch den radialen Abstand gebildeten Spalt sind der Dichtring und die Vorschaltdichtung angeordnet. Das zweite Maschinenelement ist auf ein definiertes Massepotential geerdet, wobei das erste und das zweite Maschinenelement von der Vorschaltdichtung jeweils anliegend berührt und dadurch elektrisch leitend miteinander verbunden sind.
Die Vorschaltdichtung ist als Potentialausgleichsring ausgebildet und besteht zum Beispiel aus einem elektrisch leitfähigen, mit PTFE imprägnierten Vliesstoff. Eine mechanische Beschädigung der Maschinenelemente durch einen elektrischen Spannungsdurchschlag ist folglich ausgeschlossen.
Ohne den elektrischen Potentialausgleich könnten mechanische Beschädigungen der gegeneinander abzudichtenden Maschinenelemente dadurch entstehen, dass unterschiedlich große elektrische Potentiale der Maschinenelemente durch einen elektrischen Spannungsdurchschlag ausgeglichen werden. Ein solcher Spannungsdurchschlag ist umso wahrscheinlicher, je enger die Maschinenelemente mit unterschiedlichen elektrischen Potentialen einander benachbart zugeordnet sind. Ein Spannungsdurchschlag kann einen Materialabtrag an dem Maschinenelement mit relativ geringerer Ladung bewirken und eine Veränderung des Materialgefüges in dem Bereich, in dem der Spannungsdurchschlag erfolgt. Eine wirksame Abschirmung elektromagnetischer Störwellen, insbesondere eine wirksame Abschirmung von elektromagnetischen Störwellen mit einer Frequenz ≥ 30 MHZ, ist durch das Potentialausgleichselement nicht möglich.

Aus der DE 10 2014 010 269 A1 ist eine weitere Vorschaltdichtung bekannt. Die Vorschaltdichtung umfasst eine im Wesentlichen kreisringförmig ausgebildete Scheibe aus einem elektrisch leitfähigen und luftdurchlässigen Werkstoff und einen Tragkörper, wobei die Scheibe - bezogen auf den Tragkörper - als separat erzeugtes Einzelteil ausgebildet und mit dem Tragkörper verbunden ist.

Der Tragkörper kann durch einen Dichtring gebildet sein.
Die Vorschaltdichtung hat nicht nur die Aufgabe eines Potentialausgleichs sondern auch die Aufgabe, Verunreinigungen aus der Umgebung an einem Vordringen zur Dichtlippe des Dichtrings zu verhindern.
Die Vorschaltdichtung ist eine entkoppelte elektrische Brücke. Unter "entkoppelt" wird in diesem Zusammenhang verstanden, dass die Dichtfunktion eines zum Beispiel mit der Vorschaltdichtung kombinierten Dichtrings von der Funktion der elektrischen Brücke, nämlich einen Spannungsdurchschlag zu vermeiden und einen elektrischen Potentialausgleich zwischen Maschinenelementen zu bewirken, entkoppelt ist.
Die Vorschaltdichtung steht nicht in direktem Kontakt mit dem abzudichtenden Medium. Dabei ist von Vorteil, dass der elektrische Widerstand der Vorschaltdichtung während der gesamten Gebrauchsdauer der Vorschaltdichtung im Wesentlichen konstant ist. Würde die Vorschaltdichtung mit dem abzudichtenden Medium in Kontakt gelangen, würde sich der Widerstand unkalkulierbar verändern.

Aus der DE 10 2010 018 270 A1 ist eine elektrisch leitfähige Dichtungsanordnung bekannt, die in Hybrid- und Elektrofahrzeugen zur Anwendung gelangt. Die elektrisch leitfähige Dichtungsanordnung soll verhindern, dass verteilte RF-Energie zu unerwünschten Störungen führt, zum Beispiel zu Störungen eines Radios in einem Kraftfahrzeug. Diese unerwünschten Störungen sollen dadurch verhindert werden, dass der Dichtring aus einem elektrisch leitfähigen Werkstoff besteht und elektrisch leitend zwischen einer abzudichtenden Welle und einem Gehäuse angeordnet ist.

Generell sind die zuvor genannten, elektrisch leitfähigen Werkstoffe für eine zufriedenstellende Abschirmung elektromagnetischer Störwellen nicht gut geeignet, insbesondere dann nicht, wenn der Dichtring im Zusammenhang mit e-mobility zur Anwendung gelangt und die elektromagnetischen Störwellen deshalb eine Frequenz haben, die häufig ≥ 30 MHZ ist.

Aus der JP 2014 207822 A ist eine weitere Dichtung bekannt, umfassend einen Dichtring aus einem Dichtungswerkstoff und zumindest einen Abschirmring aus einem weichmagnetischen Werkstoff zur Abschirmung elektromagnetischer Störwellen.
Dabei können mehrere Abschirmringe in einer funktionstechnischen Reihenschaltung angeordnet sein.

### Darstellung der Erfindung

Der Erfindung liegt die Aufgabe zugrunde, eine Dichtung der eingangs genannten Art derart weiterzuentwickeln, dass diese zusätzlich zur Abdichtfunktion weitere Funktionen aufweist und dadurch besonders vorteilhaft auf dem technischen Gebiet der "e-mobility" eingesetzt werden kann. Insbesondere sollen durch die Dichtung elektromagnetische Störwellen mit einer Frequenz ≥ 30 MHZ wirksam abgeschirmt werden können. Außerdem sollen unterschiedlich große elektrische Potentiale der gegeneinander abzudichtenden Maschinenelemente durch die Dichtung ausgeglichen werden können.

Diese Aufgabe wird erfindungsgemäß durch eine Dichtung gemäß Anspruch 1 gelöst.
Auf vorteilhafte Ausgestaltungen nehmen die auf Anspruch 1 direkt oder indirekt rückbezogenen Ansprüche Bezug.

Zur Lösung der Aufgabe ist eine Dichtung vorgesehen, umfassend einen Dichtring aus einem Dichtungswerkstoff und zumindest einen Abschirmring aus einem weichmagnetischen Werkstoff zur Abschirmung elektromagnetischer Störwellen, umfassend zusätzlich zum Dichtring und zum zumindest einen Abschirmring einen Potentialausgleichsring aus einem elektrisch leitfähigen Werkstoff, wobei der zumindest einen Abschirmring und der Potentialausgleichsring eine vormontierbare zweite Einheit bilden. Weichmagnetische Werkstoffe bewirken im Vergleich zu elektrisch leitfähigen Vliesstoffen oder elektrisch leitfähigen Polymeren eine stärkere Abschirmung aufgrund höherer Volumenanteile abschirmrelevanter Materialkomponenten.

Wie zuvor ausgeführt, hat sich gezeigt, dass Potentialausgleichsringe, die zwingend aus einem elektrisch leitfähigen Werkstoff bestehen müssen, um ihre Funktion zu erfüllen, nicht gut geeignet sind, elektromagnetische Störwellen wirkungsvoll abzuschirmen. Insbesondere dann, wenn die elektromagnetischen Störwellen eine Frequenz ≥ 30 MHZ haben, ist die Abschirmung nur unzureichend.

Ein Abschirmring aus einem weichmagnetischen Werkstoff ist demgegenüber sehr gut geeignet, elektromagnetische Störwellen abzuschirmen. Selbst elektromagnetische Störwellen, wie sie im Bereich der e-mobility vorkommen, nämlich elektromagnetische Störwellen mit einer Frequenz ≥ 30 MHZ, lassen sich durch solche Abschirmringe wirkungsvoll abschirmen.
Durch die zur Anwendung gelangenden weichmagnetischen Werkstoffe, bei denen es sich um ferromagnetische Materialien handelt, ist der Abschirmring, im Gegensatz zu den zuvor beschriebenen Potentialausgleichsringen, elektrisch nicht leitfähig. Dadurch ist ein solcher Abschirmring als Potentialausgleichsring ungeeignet; eine andere Aufgabe als die Abschirmung elektromagnetischer Störwellen hat der Abschirmring nicht.

Der Dichtring kann wie üblich ausgebildet sein und aus einem gebräuchlichen Dichtungswerkstoff bestehen.

Soll die Dichtung nicht nur, wie zuvor beschrieben, dichten und gleichzeitig elektromagnetische Störwellen durch den Abschirmring abschirmen können, sondern außerdem, wie eingangs beschrieben, auch für einen Potentialausgleich sorgen, kann es vorgesehen sein, dass der Dichtring aus einem elektrisch leitfähigen Dichtungswerkstoff besteht. Durch den Dichtring aus elektrisch leitfähigem Dichtungswerkstoff können unterschiedliche Potentiale zwischen den gegeneinander abzudichtenden Maschinenelementen ausgeglichen und Spannungsdurchschläge und daraus resultierende Beschädigungen der gegeneinander abzudichtenden Maschinenelemente vermieden werden.

Zusätzlich oder alternativ ist es vorgesehen, dass die Dichtung zusätzlich zum Dichtring und zum zumindest einen Abschirmring zumindest einen Potentialausgleichsring aus einem elektrisch leitfähigen Werkstoff umfasst.

Ein solcher Potentialausgleichsring kann, wie eingangs ausgeführt, durch einen luftdurchlässigen und elektrisch leitfähigen Vliesstoffring gebildet sein. Alternativ kann der Potentialausgleichsring aus einem elektrisch leitfähigen polymeren Werkstoff bestehen.
Abhängig vom Anwendungsfall können zum Beispiel zwei Potentialausgleichsringe vorgesehen sein.

Bei einer solchen multifunktionalen Dichtung ist von Vorteil, dass diese drei grundsätzlich voneinander abweichende Funktionen in sich vereint. Der Dichtring aus dem Dichtungswerkstoff sorgt dafür, dass zwei Maschinenelemente zuverlässig gegeneinander abgedichtet werden.
Der Abschirmring aus einem weichmagnetischen Werkstoff sorgt gleichzeitig dafür, dass elektromagnetische Störwellen wirkungsvoll abgeschirmt werden und zwar auch dann, wenn die gegeneinander abzudichtenden Maschinenelemente im Zusammenhang mit e-mobility zur Anwendung gelangen und elektromagnetische Störwellen mit einer Frequenz ≥ 30 MHZ bedämpft werden sollen.
Zusätzlich kann eine Potential-Ausgleichsfunktion dadurch erreicht werden, dass der Dichtring entweder aus einem elektrisch leitfähigen Dichtungswerkstoff besteht oder dass zusätzlich ein Potentialausgleichsring aus einem elektrisch leitfähigen Werkstoff zur Anwendung gelangt. In beiden Fällen werden dann Spannungsdurchschläge zwischen den gegeneinander abzudichtenden Maschinenelementen vermieden.

Eine gute Wirkungsweise von Abschirmring und Potentialausgleich lässt sich nur dann gewährleisten, wenn eine strikte funktionale Trennung vorgenommen wird. Dadurch, dass der Abschirmring nicht elektrisch leitfähig/isolierend ist, ist er für einen Potentialausgleich nicht geeignet.

Umgekehrt kann ein Dichtring aus einem elektrisch leitfähigen Dichtungswerkstoff nicht für eine wirksame Abschirmung elektromagnetischer Störwellen sorgen,insbesondere dann nicht, wenn die elektromagnetischen Störwellen hochfrequent sind, in einem Frequenzbereich ≥ 30 MHZ. Auch ein separat erzeugter Potentialausgleichsring, der aus einem elektrisch leitfähigen Werkstoff besteht, ist dazu nicht in der Lage.

Es ist vorgesehen, dass der zumindest eine Abschirmring und der Potentialausgleichsring eine vormontierbare Einheit bilden. Hierbei ist von Vorteil, dass die Dichtung aus wenigen Einzelteilen besteht, dadurch einen einfachen Aufbau aufweist und die Gefahr von Montagefehlern auf ein Minimum begrenzt ist.

Gemäß einer vorteilhaften Ausgestaltung kann es vorgesehen sein, dass der Abschirmring durch einen Ferritring gebildet ist. Ein solcher Ferritring ist praktisch elektrisch nicht leitend/elektrisch isolierend. Der Ferritring kann aus Sinterkeramik bestehen. Die Werkstoffe, aus denen weichmagnetische Ferritringe bestehen, sind allgemein bekannt und nicht Gegenstand der vorliegenden Erfindung.
Dadurch, dass weichmagnetische Ferrite, wie zuvor beschrieben, elektrisch nicht leitfähig/isolierend sind, treten keine Wirbelstromverluste auf und sie sind sogar zur Abschirmung von elektromagnetischen Störwellen mit hohen Frequenzen im Bereich von ≥ 30 MHZ gut geeignet.

In Abhängigkeit von den jeweiligen Gegebenheiten des Anwendungsfalles, insbesondere in Abhängigkeit von der Frequenz der abzuschirmenden, elektromagnetischen Störwellen, kann es vorgesehen sein, dass zumindest zwei Abschirmringe in einer funktionstechnischen Reihenschaltung angeordnet sind.

Eine solche funktionstechnische Reihenschaltung kann dadurch erreicht werden, dass die zumindest zwei Abschirmringe in axialer Richtung benachbart zueinander angeordnet sind und eine vormontierbare Einheit bilden. Je höher die Anzahl der zur Anwendung gelangenden Abschirmringe, desto besser werden auch hochfrequente, elektromagnetische Störwellen bedämpft.

### Kurzbeschreibung der Zeichnung

Drei Ausführungsbeispiele der erfindungsgemäßen Dichtung sind in den Figuren 1 bis 3 gezeigt und werden nachfolgend näher beschrieben.

Die Figuren 1 bis 3 zeigen jeweils in schematischer Darstellung:
Figur 1 ein erstes Ausführungsbeispiel einer Dichtung, die den Dichtring 1 und den Abschirmring 2 umfasst,
Figur 2 ein zweites Ausführungsbeispiel, bei dem zusätzlich zum Ausführungsbeispiel aus Figur 1 ein Potentialausgleichsring zur Anwendung gelangt,
Figur 3 ein drittes Ausführungsbeispiel, ähnlich den Ausführungsbeispielen aus den Figuren 1 und 2, wobei insgesamt drei Abschirmringe zur Anwendung gelangen, die funktionstechnisch in Reihe geschaltet sind.

### Ausführung der Erfindung

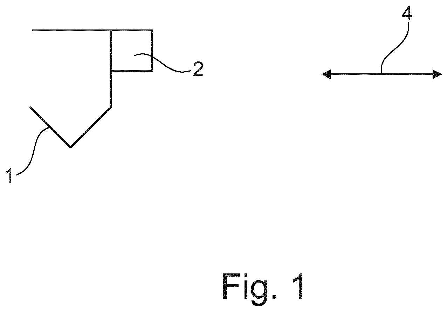

Die Dichtungen aus den Figuren 1 bis 3 umfassen jeweils einen Dichtring 1, der aus einem Dichtungswerkstoff besteht.

Der Dichtring gelangt im Bereich e-mobility zur Abdichtung von zwei nicht dargestellten Maschinenelementen zur Anwendung.

Zusätzlich zum Dichtring 1 gelangt der Abschirmring 2 zur Anwendung, der in dem hier gezeigten Ausführungsbeispiel durch einen weichmagnetischen Ferritring gebildet ist. Der Abschirmring schirmt elektromagnetische Störwellen ab; eine andere/zusätzliche Aufgabe hat der Abschirmring 2 nicht.

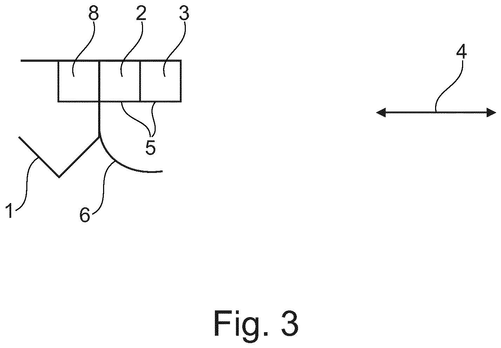

Die gezeigten Darstellungen in den Figuren 1 und 3 sind jeweils nur exemplarisch.
Es versteht sich von selbst, dass der Abschirmring 2 an unterschiedlichsten Stellen des Dichtrings 1 angeordnet und mit dem Dichtring 1 verbunden sein kann.

Dargestellt ist der Abschirmring 2 auf der einem abzudichtenden Raum axial abgewandten Seite des Dichtrings 1, "außerhalb" des Dichtrings 1.
In Abhängigkeit von den jeweiligen Gegebenheiten des Anwendungsfalles, insbesondere dann, wenn der axiale Bauraum für die Dichtung sehr begrenzt ist, besteht jedoch auch die Möglichkeit, den Abschirmring 2 "innerhalb" des Dichtrings 1 anzuordnen. Der Einbauraum des Abschirmrings 2 wäre dann, wie der Einbauraum des Abschirmrings 8 aus Figur 3, durch den Axial- und den Radialschenkel des Dichtrings 1 begrenzt.

In Figur 2 umfasst die Dichtung nicht nur, wie in Figur 1, den Dichtring 1 und den Abschirmring 2 sondern zusätzlich einen Potentialausgleichsring 6 aus einem elektrisch leitfähigen Werkstoff. Die Funktionen "Abdichtung", "Abschirmung elektromagnetischer Störwellen" und "Potentialausgleich" sind in einer Dichtung vereint.

Entscheidend ist die Funktionstrennung zwischen Abschirmung und Potentialausgleich. Die Abschirmung erfolgt durch einen elektrisch nicht leitfähigen/isolierenden, weichmagnetischen Werkstoff, der Potentialausgleich demgegenüber durch einen elektrisch leitfähigen Werkstoff.
Durch die Funktionstrennung sind der Abschirmring und der Potentialausgleichsring jeweils funktionstechnisch individualisiert und optimal zur Lösung ihrer jeweiligen Aufgaben ausgelegt.

In Figur 3 ist ein Ausführungsbeispiel gezeigt, ähnlich den Ausführungsbeispielen aus Figur 1 und Figur 2, wobei zwei Abschirmringe 2, 3 zur Anwendung gelangen, die in einer funktionstechnischen Reihenschaltung angeordnet sind.
Die beiden Abschirmringe 2, 3 bilden eine vormontierbare erste Einheit 5.
Die vormontierbare erste Einheit 5 ist "außerhalb", auf der einem abzudichtenden Raum axial abgewandten Seite des Dichtrings 1 angeordnet. Um elektromagnetische Störwellen noch besser abschirmen zu können, ist außerdem ein weiterer Abschirmring 8 vorgesehen, der "innerhalb" des Dichtrings 1 in einer funktionstechnischen Reihenschaltung mit der vormontierbaren ersten Einheit 5 angeordnet ist.
Außerdem ist ein Potentialausgleichsring 6 Bestandteil der gezeigten Dichtung, um Spannungsdurchschläge zu vermeiden.

## Patentansprüche

1. Dichtung, umfassend einen Dichtring (1) aus einem Dichtungswerkstoff und zumindest einen Abschirmring (2, 3, 8) aus einem weichmagnetischen Werkstoff zur Abschirmung elektromagnetischer Störwellen, umfassend zusätzlich zum Dichtring (1) und zum zumindest einen Abschirmring (2, 3, 8) einen Potenzialausgleichsring (6) aus einem elektrisch leitfähigen Werkstoff, wobei der zumindest eine Abschirmring (2) und der Potentialausgleichsring (6) eine vormontierbare zweite Einheit (7) bilden.

2. Dichtung nach Anspruch 1, **dadurch gekennzeichnet, dass** der Potentialausgleichsring (6) durch einen luftdurchlässigen und elektrisch leitfähigen Vliesstoffring gebildet ist.

3. Dichtung nach einem der Ansprüche 1 oder 2, **dadurch gekennzeichnet, dass** der zumindest eine Abschirmring (2, 3, 8) durch einen Ferritring gebildet ist.

4. Dichtung nach einem der Ansprüche 1 bis 3, **dadurch gekennzeichnet, dass** zumindest zwei Abschirmringe (2, 3, 8) in einer funktionstechnischen Reihenschaltung angeordnet sind.

5. Dichtung nach Anspruch 4, **dadurch gekennzeichnet, dass** die zumindest zwei Abschirmringe (2, 3) in axialer Richtung (4) benachbart zueinander angeordnet sind und eine vormontierbare erste Einheit (5) bilden.

6. Dichtung nach Anspruch 1, **dadurch gekennzeichnet, dass** der Dichtring (1) aus einem elektrisch leitfähigen Dichtungswerkstoff besteht.

## Claims

1. Seal comprising a sealing ring (1) composed of a seal material and at least one shielding ring (2, 3, 8) composed of a soft-magnetic material for shielding electromagnetic interference waves, comprising, in addition to the sealing ring (1) and the at least one shielding ring (2, 3, 8), a potential equalization ring (6) composed of an electrically conductive material, wherein the at least one shielding ring (2) and the potential equalization ring (6) form a second unit (7) which can be preassembled.

2. Seal according to Claim 1, **characterized in that** the potential equalization ring (6) is formed by an air-permeable and electrically conductive non-woven ring.

3. Seal according to one of Claims 1 or 2, **characterized in that** the at least one shielding ring (2, 3, 8) is formed by a ferrite ring.

4. Seal according to one of Claims 1 to 3, **characterized in that** at least two shielding rings (2, 3, 8) are arranged in a functional series circuit.

5. Seal according to Claim 4, **characterized in that** the at least two shielding rings (2, 3) are arranged adjacent to one another in the axial direction (4) and form a first unit (5) which can be preassembled.

6. Seal according to Claim 1, **characterized in that** the sealing ring (1) consists of an electrically conductive seal material.

## Revendications

1. Joint d'étanchéité, comprenant une bague d'étanchéité (1) en matériau d'étanchéité et au moins une bague de blindage (2, 3, 8) en matériau magnétique doux pour le blindage contre les ondes électromagnétiques parasites, comprenant, outre la bague d'étanchéité (1) et ladite au moins une bague de blindage (2, 3, 8), une bague de compensation de potentiel (6) en matériau électriquement conducteur, dans lequel ladite au moins une bague de blindage (2) et la bague de compensation de potentiel (6) forment une deuxième unité pouvant être préassemblée (7).

2. Joint d'étanchéité selon la revendication 1, **caractérisé en ce que** la bague de compensation de potentiel (6) est formée par une bague de non tissé perméable à l'air et électriquement conductrice.

3. Joint d'étanchéité selon l'une des revendications 1 ou 2, **caractérisé en ce que** ladite au moins une bague de blindage (2, 3, 8) est formée par une bague de ferrite.

4. Joint d'étanchéité selon l'une des revendications 1 à 3, **caractérisé en ce qu'**au moins deux bagues de blindage (2, 3, 8) sont disposées dans un montage en série fonctionnel.

5. Joint d'étanchéité selon la revendication 4, **caractérisé en ce que** lesdites au moins deux bagues de blindage (2, 3) sont disposées l'une à côté de l'autre dans la direction axiale (4) et forment une première unité pouvant être préassemblée (5).

6. Joint d'étanchéité selon la revendication 1, **caractérisé en ce que** le joint d'étanchéité (1) est constitué d'un matériau d'étanchéité électriquement conducteur.
